# EUROPEAN PATENT SPECIFICATION

(11) **EP 2 921 572 B1**
(45) Date of publication and mention of the grant of the patent: **24.06.2020**
(21) Application number: 13855906.7
(22) Date of filing: 13.11.2013
(51) Int. Cl.: C23C 14/24, C23C 14/32, B23P 15/28, C23C 14/35, C23C 14/50, C23C 14/06

(54) **FILM DEPOSITION DEVICE**
FILMABLAGERUNGSVORRICHTUNG
DISPOSITIF DE DÉPÔT

(30) Priority: 14.11.2012 JP 2012250280
(43) Date of publication of application: 23.09.2015
(73) Proprietor: Kabushiki Kaisha Kobe Seiko Sho (Kobe Steel, Ltd.), Kobe-shi, Hyogo 651-8585 (JP)
(72) Inventor: FUJII, Hirofumi, Hyogo 676-8670 (JP)
(74) Representative: TBK
(86) International application number: PCT/JP2013/006677
(87) International publication number: WO 2014/076947

(56) References cited:
- JP-A- S6 270 573
- JP-A- S6 360 275
- JP-A- H06 212 424
- JP-A- H06 212 424
- JP-A- 2004 269 948
- JP-A- 2006 152 441
- JP-A- 2007 138 286
- JP-A- 2007 314 873
- JP-A- 2012 214 834
- KR-B1- 100 758 694
- US-A- 5 580 429

## Description

### TECHNICAL FIELD

The present invention relates to a film deposition device that performs a PVD treatment.

### BACKGROUND ART

In general, in order to improve abrasion resistance of a cutting tool or a sliding characteristic of a sliding surface of a machine part, a hard film (of TiN, TiAlN, CrN, or the like) is formed on a surface of a substrate (an object for film deposition) which will become the cutting tool or the machine part using a physical vapor deposition (PVD) method. For example, a film deposition device such as an arc ion plating (AIP) apparatus or a sputtering apparatus can be used as equipment used to form the hard film.

As the film deposition device that performs a PVD treatment, a film deposition device is known which includes a vacuum chamber accommodating a substrate, plural evaporation sources installed in the vacuum chamber, and a worktable having the substrate mounted thereon and causing the substrate to rotate around the evaporation sources and which performs a PVD treatment on the surface of the substrate mounted on the worktable. The worktable rotates around a vertical rotation axis and causes the substrate mounted on the worktable to rotate around a vertical axis which is the center thereof, that is, to rotate on its axis, with the rotation. The evaporation sources are arranged so as to be parallel to the rotation axis of the worktable.

As the film deposition device that performs the above described PVD treatment, a film deposition device including a vacuum chamber and plural film-forming evaporation sources arranged in the vacuum chamber is disclosed in Patent Document 1. The film-forming evaporation sources are arranged to face a substrate mounted on the worktable and are arranged in a line at almost constant pitches without overlapping in the height direction of the vacuum chamber. In the film deposition device, metal ions are evaporated from evaporation materials attached to the evaporation sources by causing the film-forming evaporation sources to generate vacuum arc discharges and the metal ions are applied to the surface of the substrate, whereby a film deposition treatment is performed.

When a hard film is formed on a surface of a substrate using the film deposition device according to the related art disclosed in Patent Document 1, a substantially uniform hard film may not be formed on the entire surface of the substrate as an object for film deposition. In general, in reactant gas such as nitrogen or hydrocarbon-based gas (such as methane or acetylene), plural evaporation sources arranged in a vacuum chamber are caused to generate vacuum arc discharge to evaporate evaporation materials attached to the evaporation sources, and the generated metal ions are applied to the surface of a substrate to form a hard film such as a nitride film or a carbide film. When a hard film is formed on the surface of a substrate in this way, the film thickness varies in the length direction of the substrate (the direction along the rotation axis of the worktable, that is, the vertical axis direction). Particularly, the film thickness of the surface of the substrate is the largest in the middle part in the length direction of the substrate, is the smallest at one or more of both ends of the substrate, and the difference therebetween is marked. Accordingly, even when a hard film is formed on the surface of a substrate using the film deposition device according to the related art, the film formed on the substrate does not have a substantially uniform thickness which is desired by an operator.

Patent Document 2 discloses a film deposition device as specified in the preamble of claim 1.

### CITATION LIST

### PATENT DOCUMENT

Patent Document 1: JP 4693002 B2
Patent Document 2: JP S63 60275 A

### SUMMARY OF THE INVENTION

An object of the present invention is to provide a film deposition device that forms a film by performing a PVD treatment on surfaces of plural substrates and that can enhance uniformity in thickness of the film.

According to an aspect of the present invention, there is provided a film deposition device including the features set forth in claim 1.

### BRIEF DESCRIPTION OF DRAWINGS

[Fig. 1] Fig. 1 is a diagram illustrating a film deposition device according to a first embodiment of the present invention.
[Fig. 2] Fig. 2 is an enlarged view of the film deposition device according to the first embodiment.
[Fig. 3] Fig. 3 is a diagram illustrating gaps between evaporation sources and substrates.
[Fig. 4] Fig. 4 is a diagram illustrating a film thickness distribution which is acquired by forming a film under Condition 1 using the apparatus illustrated in Fig. 1.
[Fig. 5] Fig. 5 is a diagram illustrating a film thickness distribution which is acquired by forming a film under Condition 2 using the apparatus illustrated in Fig. 1.
[Fig. 6] Fig. 6 is a diagram illustrating a film thickness distribution which is acquired by forming a film under Condition 3 using the apparatus illustrated in Fig. 1.
[Fig. 7] Fig. 7 is a diagram illustrating a film thickness distribution which is acquired by forming a film under Condition 4 using the apparatus illustrated in Fig. 1.
[Fig. 8] Fig. 8 is a diagram illustrating a film deposition device according to a second embodiment of the present invention.
[Fig. 9] Fig. 9 is a diagram illustrating a film thickness distribution which is acquired by forming a film under Condition 5 using the apparatus illustrated in Fig. 8.
[Fig. 10] Fig. 10 is a diagram illustrating a film thickness distribution which is acquired by forming a film under Condition 6 using the apparatus illustrated in Fig. 8.
[Fig. 11] Fig. 11 is a diagram illustrating a film thickness distribution which is acquired by forming a film under Condition 7 using the apparatus illustrated in Fig. 8.
[Fig. 12] Fig. 12 is a diagram illustrating a film thickness distribution which is acquired by forming a film under Condition 8 using the apparatus illustrated in Fig. 8.
[Fig. 13] Fig. 13 is a plan view schematically illustrating a film deposition device according to a third embodiment of the present invention.
[Fig. 14] Fig. 14 is a cross-sectional view taken along Line XIV-XIV of Fig. 13.

### DESCRIPTION OF EMBODIMENTS

Hereinafter, embodiments of the present invention will be described with reference to the accompanying drawings.

### [First Embodiment]

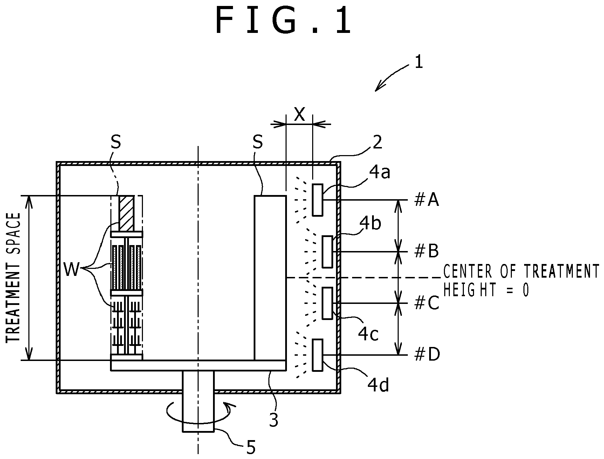

Fig. 1 illustrates a film deposition device 1 (PVD treatment apparatus) according to a first embodiment of the present invention. The film deposition device 1 includes a vacuum chamber 2 that accommodates plural substrates W (workpieces) and is an apparatus that forms a hard film on the surfaces of the substrates W (workpieces) arranged in the vacuum chamber 2 using a physical vapor deposition (PVD) method. Examples of the film deposition device 1 include an AIP apparatus that forms a film using an arc ion plating method and a sputtering apparatus that forms a film using a sputtering method.

Various substrates can be considered as the substrate W on which a film is formed using the film deposition device 1 and examples thereof include a cutting tool and a mold that is used for press work. Since a large load is applied to the cutting tool or the mold at the time of cutting work or press work thereon, there is demand for improvement in abrasion resistance or sliding characteristics. In order to achieve improvement in such characteristics, a hard film (of TiN, TiAlN, or the like) is formed on a surface of a substrate W using a PVD method.

In the following description, the up and down direction in Fig. 1 is defined to be the up and down direction of the film deposition device 1 and the vacuum chamber 2, and the right and left direction in Fig. 1 is defined to be the right and left direction of the film deposition device 1 and the vacuum chamber 2. The depth direction in Fig. 1 is defined to be the front to back direction of the film deposition device 1 and the vacuum chamber 2.

Details of the film deposition device 1 according to the first embodiment will be described below.

As illustrated in Fig. 1, the vacuum chamber 2 of the film deposition device 1 according to the first embodiment accommodates plural substrate sets S each including plural substrates W. The film deposition device 1 includes plural evaporation sources 4a, 4b, 4c, and 4d installed on the inner wall surface of the vacuum chamber 2, a worktable 3 as a substrate support member, and a discharge power source (not illustrated) that causes the plural evaporation sources 4a to 4d arranged in the vacuum chamber 2 to generate vacuum arc discharge, in addition to the vacuum chamber 2. A bias power source (not illustrated) that applies a negative voltage to the arranged substrates W is connected to the worktable 3.

The worktable 3 supports the substrate sets S accommodated in the vacuum chamber 2 and causes the substrate sets S to rotate around a substrate rotation axis given to the substrate sets S. However, in the present invention, the direction in which the substrate support member causes the substrates to move is not particularly limited. For example, the substrate support member may cause the substrates to move in a straight locus as will be described later in a third embodiment. In the present invention, when the substrates move in a locus other than a straight locus, "the direction in which the substrate support member causes the substrates to move" means a tangential direction of the movement locus.

The worktable 3 according to the first embodiment supports the substrate sets S in a posture in which the substrate sets S extend in the up and down direction. The worktable 3 enables formation of a hard film on the substrates W arranged in the substrate sets S by causing the substrate sets S to rotate around the substrate rotation axis, specifically, the central axis of the substrate sets S, that is, the axis extending in the up and down direction. However, in the present invention, even when the substrates W are arranged in the vacuum chamber 2 so as to rotate around an axis extending in the right and left direction, a hard film can be formed on the substrates W.

The vacuum chamber 2 is a hollow housing having a hexahedral shape such as a regular hexahedral shape or a rectangular hexahedral shape. The vacuum chamber 2 is a vessel which can depressurize the inside thereof up to a vacuum state and which can air-tightly maintain the inside in the vacuum state. A door (not illustrated) for inputting substrates W before film deposition into the vacuum chamber 2 or outputting substrates W after film deposition from the vacuum chamber 2 to the outside is installed on a sidewall of the vacuum chamber 2 so as to be opened or closed. The vacuum chamber 2 is provided with a gas introduction port (not illustrated) for introducing reactant gas such as nitrogen into the vacuum chamber 2 and a gas discharge port (not illustrated) for discharging reactant gas from the vacuum chamber 2.

The worktable 3 is disposed on the bottom of the vacuum chamber 2. The worktable 3 holds the plural substrate sets S. Each substrate set S includes the plural substrates W. The worktable 3 includes a table body and a substrate holding unit not illustrated in the drawings.

The table body is a disc-shaped table and includes a flat top surface. The plural substrate sets S can be arranged at plural positions arranged on the top surface in an upright posture, that is, a posture in which the length direction of the substrate sets S is parallel to the up and down direction. The table body of the worktable 3 is supported by a rotary support member 5 installed at almost the center of the bottom of the vacuum chamber 2. The rotary support member 5 is rotatable around a table rotation axis which is a vertical axis. The film deposition device 1 includes a motor that rotationally drives the rotary support member 5 and the worktable 3. The rotary support member 5 supports the worktable 3 so that the central axis thereof is substantially coincident with a vertical axis passing through the center of the worktable 3 to be concentric with the vertical axis. Accordingly, by causing the rotary support member 5 to rotate around the central axis thereof, the worktable 3 also rotates around the central axis of the rotary support member 5, that is, the table rotation axis.

The substrate holding unit holds the substrate sets S and causes the substrate sets S to rotate around the substrate rotation axis. The substrate holding unit includes plural discs, plural rotation axes connected to the discs respectively, and an interlocking mechanism. The discs are at plural positions which are arranged on the top surface of the table body and which are arranged in the circumferential direction at regular intervals in a circle concentric with the axis of the table body. Each rotation axis is fixed to the center of the bottom of the corresponding disc such that the center thereof and the center of the rotation axis extend in the up and down direction. Each rotation axis is supported by the table body so as to be rotatable around the vertical central axis, that is, around the substrate rotation axis. Each rotation axis causes the substrate set S placed on the corresponding disc to rotate around the central axis of the substrate set S by rotating itself around the substrate rotation axis.

The interlocking mechanism is constituted, for example, by a known gear mechanism. The interlocking mechanism causes the rotation axes, the discs, and the substrate sets S placed thereon to rotate around the substrate rotation axes so as to interlock with the rotation of the table body around the table rotation axis. In this way, each substrate set S revolves around the table rotation axis and rotates at the positions held on the worktable 3 through the use of the interlocking mechanism (not illustrated) by interlocking with the revolution. That is, each substrate set rotates on its axis.

The plural evaporation sources 4a to 4d are arranged at positions extending in the right and left direction with respect to the worktable 3 on which the substrate sets S are arranged as described above on the inner wall surface of the vacuum chamber 2. The evaporation sources 4a to 4d each include an evaporation material holding member and an evaporation material attached to the evaporation material holding member. Metal ions are generated by the evaporation of the evaporation material and are applied to the surfaces of the substrates W.

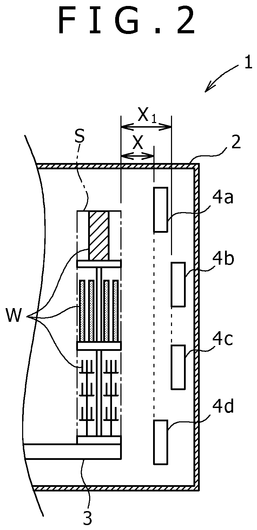

As illustrated in Figs. 1 and 2, the evaporation sources 4a to 4d according to the first embodiment are arranged on the inner wall surface on one side of the vacuum chamber 2 (on the right inner side wall surface of the vacuum chamber 2 in Fig. 1). The evaporation sources 4a to 4d are arranged at four positions in parallel in the direction along the table rotation axis, that is, in the up and down direction perpendicular to the direction in which the worktable 3 causes the substrates W to move, in a region facing the substrate sets S in the radius direction of the worktable 3.

The evaporation sources 4a and 4d out of the evaporation sources 4a to 4d illustrated in Figs. 1 and 2 correspond to the first evaporation source and are disposed to face both ends of the substrate sets S supported by the worktable 3. The evaporation source 4a is disposed so that the height of the top surface of the evaporation source 4a corresponds to the height of the top end of the substrate sets S or the evaporation source 4a slightly protrudes upward from the top end of the substrate sets S. Similarly, the evaporation source 4d is disposed so that the height of the bottom surface of the evaporation source 4d corresponds to the height of the bottom surface of the substrate sets S or the evaporation source 4d slightly protrudes downward from the bottom surface of the substrate sets S.

The evaporation sources 4b and 4c correspond to a pair of second evaporation sources and are disposed to be adjacent to the inside of the respective evaporation sources 4a and 4d. The aforementioned four evaporation sources 4a to 4d have the substantially same size (size in the up and down direction). For example, the evaporation materials of the evaporation sources 4a to 4d have a circular shape when viewed from the table rotation axis and have a diameter of about φ100 mm.

The evaporation source 4a is disposed at a height position #A which slightly protrudes upward from the top end of the substrate sets S and the evaporation source 4d is disposed at a height position #D which slightly protrudes downward from the bottom end of the substrate sets S. The evaporation sources 4b and 4c are disposed between the evaporation source 4a and the evaporation source 4d and are disposed at height positions #B and #C, respectively, which are arranged at a regular interval (regular pitch) along the direction of the table rotation axis. As described above, the evaporation sources 4a and 4d correspond to the first evaporation sources disposed at the positions facing both ends of the substrate sets S and the evaporation sources 4b and 4c correspond to the second evaporation sources disposed to be adjacent to the first evaporation sources.

As illustrated in Fig. 2, the evaporation source 4a is disposed so as to further protrude toward the substrate sets S than the evaporation source 4b. In other words, the evaporation source 4a is disposed at a position closer to the substrate sets S than the evaporation source 4b adjacent to the inside of the evaporation source 4a. That is, the distance (X) between the substrate sets S and the evaporation source 4a is smaller than the distance (X₁) between the substrate sets S and the evaporation source 4b (X < X₁). Similarly to the evaporation source 4a, the evaporation source 4d is disposed so as to further protrude toward the substrate sets S than the evaporation source 4c adjacent to the inside of the evaporation source 4d. In other words, the evaporation source 4d is disposed at a position closer to the substrate sets S than the evaporation source 4c. That is, the four evaporation sources 4a to 4d according to this embodiment are arranged in an inverted C shape along the direction of the table rotation axis in a front view.

The arrangement shape of the evaporation sources 4a to 4d when viewed from the table rotation axis is not particularly limited. For example, the evaporation sources 4a to 4d may be arranged in a straight line along the table rotation axis or may be arranged in a nonlinear shape, for example, in a zigzag shape or a spiral shape, when viewed from the table rotation axis.

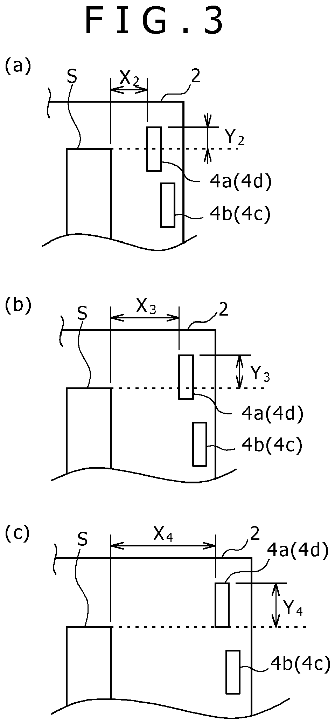

Figs. 3 (a) to (c) illustrate examples of a positional relationship among an arbitrary substrate set S, the evaporation source 4a (first evaporation source) as the first evaporation source which is disposed at the position facing the top end of the substrate set S, and the evaporation source 4b as the second evaporation source adjacent to the inside of the first evaporation source along the direction of the table rotation axis. Fig. 3 (a) illustrates the position of the evaporation source 4a in the up and down direction, that is, the position (height position) in the direction parallel to the table rotation axis, when the evaporation source 4a as the first evaporation source disposed at the position facing the top end of the substrate set S is located at a position close to the substrate set S in the radius direction. Similarly, Fig. 3 (b) illustrates the position of the evaporation source 4a in the up and down direction when the evaporation source 4a is located at a position separated far in the radius direction from the substrate set S than the position illustrated in Fig. 3 (a), and Fig. 3 (c) illustrates the position of the evaporation source 4a in the up and down direction when the evaporation source 4a is located at a position separated farther in the radius direction from the substrate set S.

As illustrated in Figs. 3 (a) to (c), the evaporation source 4a disposed at the position facing the top end of the substrate set S is arranged so as to further protrude upward from the end (the top end in Figs. 3 (a) to (c)) of the substrate set S along the direction of the table rotation axis as the distance (distances X₂, X₃, and X₄ illustrated in Figs. 3 (a) to (c)) in the radius direction from the substrate set S increases, that is, so as to increase the upward protruding length (protruding lengths Y₂, Y₃, and Y₄ illustrated in Figs. 3 (a) to (c)) of the evaporation source 4a from the top end of the substrate set S (X₂ < X₃ < X₄ and Y₂ < Y₃ < Y₄). The evaporation source 4b as the second evaporation source adjacent to the evaporation source 4a is disposed so as to be closer to the end of the substrate set S along the direction parallel to the table rotation axis as the distance from the substrate set S increases, similarly to the arrangement of the evaporation source 4a.

The same relationship is established for the evaporation source 4d as the first evaporation source disposed to face the bottom end of the substrate set S. By arranging the evaporation sources 4a and 4d in this way, it is possible to treat the substrate set S even when the distances between the substrate set S and the evaporation sources 4a and 4d need to be increased due to structural restrictions of the vacuum chamber 2 or restrictions (material, size, and the like) of the substrates W.

### [Experimental Examples]

Experimental examples in which a hard film is formed on the surfaces of substrates W using the film deposition device 1 illustrated in Fig. 1 will be described below with reference to the accompanying drawings.

As illustrated in Fig. 1, first, plural substrate sets S (for example, with a height of 600 mm) each including plural substrates W as an object for film deposition are placed on the rotary worktable 3 (for example, φ700 mm) in the vacuum chamber 2. Thereafter, the inside of the vacuum chamber 2 is exhausted to form an almost vacuum state, for example, a state with a nitrogen pressure of about 3 Pa.

On the other hand, an arc current of 100 A is supplied from the discharge power source to the evaporation sources 4a to 4d and a bias voltage of 30 V for applying a negative voltage is applied to the substrates W on the worktable 3 from the bias power source. The process of forming a hard film on the surfaces of the substrates W in this way is continuously performed for two hours. The range (treatment space) in which the film deposition treatment is performed on the substrates W is defined to be the entire length in the direction of the rotation axes of the substrate sets S. The position of the treatment center of the substrate sets S, that is, the position of the center in the height direction of the treatment region of the substrate sets S, is a position 300 mm above the bottom end of the substrate sets S. That is, the central position in the height direction of the treatment region is set to the central position of the substrate sets S in the direction of the substrate rotation axes (up and down direction) of the substrate sets S.

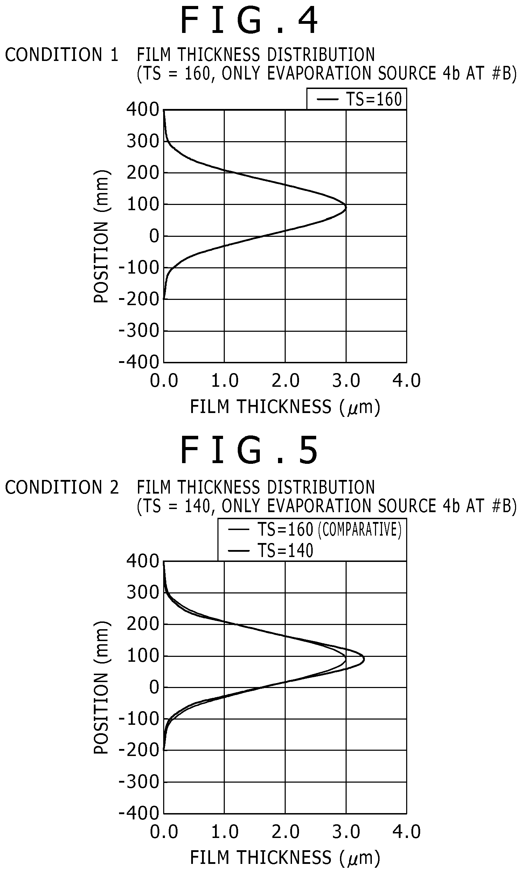

The results of the experimental examples in which a hard film is formed on the surfaces of the substrates W will be described below with reference to Table 1 and Figs. 4 to 7. Table 1 shows the results of the experimental examples in which a hard film is formed on the surfaces of the substrates W under Conditions 1 to 4 using the film deposition device 1 illustrated in Fig. 1, and Figs. 4 to 7 are graphs illustrating the results of the experimental examples.

**[Table 1]**

| Distance (TS distance) between Target and Substrate (object to be treated): X | | | | | |
|---|---|---|---|---|---|
| (-: not used, unit: mm) | | | | | |
| Arrangement of evaporation sources | | Condition 1 | Condition 2 | Condition 3 | Condition 4 |
| | | (one target) | (one target) | (four targets) | (four targets) |
| | | TS distance (X) | TS distance (X) | TS distance (X) | TS distance (X) |
| Evaporation source | 4a (#A) | - | - | 160 | 140 |
| | 4b (#B) | 160 | 140 | 160 | 160 |
| | 4c (#C) | - | - | 160 | 160 |
| | 4d (#D) | - | - | 160 | 140 |
| Film thickness distribution | Maximum value | - | - | 3.44 µm | 3.57 µm |
| | Minimum value | - | - | 2.88 µm | 3.13 µm |
| | Central value | 3.0 µm | 3.3 µm | 3.16 µm | 3.35 µm |
| | Deviation | - | - | ±8.9% | ±6.6% |

Fig. 4 illustrates the result of the film deposition treatment under Condition 1. The film deposition under Condition 1 corresponds to a first comparative example. In Condition 1, a hard film was formed on the surfaces of the substrates W using one (for example, the evaporation source 4b) of the plural evaporation sources. The evaporation source 4b is disposed such that the center of the evaporation source 4b is located 100 mm above the treatment center of the substrate sets S (the central position in the height direction of the treatment region), and the distance (TS distance: X₁) between the evaporation source 4b and the substrate sets S was 160 mm. As the result of the film deposition under Condition 1, the maximum value of the film thickness of the substrates W was 3.0 µm. As illustrated in Fig. 4, the curve indicating the film thickness distribution is chevron curve which has a peak in film thickness (which indicates that the hard film is thickest) at the position corresponding to the evaporation source 4b and in which the hard film becomes thinner toward the top and bottom of the substrates W.

Fig. 5 illustrates the result of the film deposition treatment under Condition 2. The film deposition under Condition 2 corresponds to a second comparative example. In Condition 2, a hard film was formed on the surfaces of the substrates W using the evaporation source 4b which is one of the plural evaporation sources. The evaporation source 4b is disposed such that the center of the evaporation source 4b is located 100 mm above the treatment center of the substrate sets S, and the distance (TS distance: X) between the evaporation source 4b and the substrate sets S was 140 mm which was smaller than that in Condition 1 (X < X₁). As a result, the maximum value of the film thickness of the substrates W was 3.3 µm. As illustrated in Fig. 5, the curve indicating the film thickness distribution is chevron curve which has a peak in film thickness (which indicates that the hard film is thickest) at the position corresponding to the evaporation source 4b and in which the hard film becomes thinner toward the top and bottom of the substrates W. That is, the curve is a curve protruding sharper than the curve corresponding to Condition 1 illustrated in Fig. 4. Accordingly, when the evaporation source gets closer to the substrate sets S, it can be confirmed that the thickness of the hard film formed on the substrates W becomes larger in the vicinity of the central axis of the evaporation source and becomes smaller at positions separated about 100 mm or more in the up and down direction therefrom.

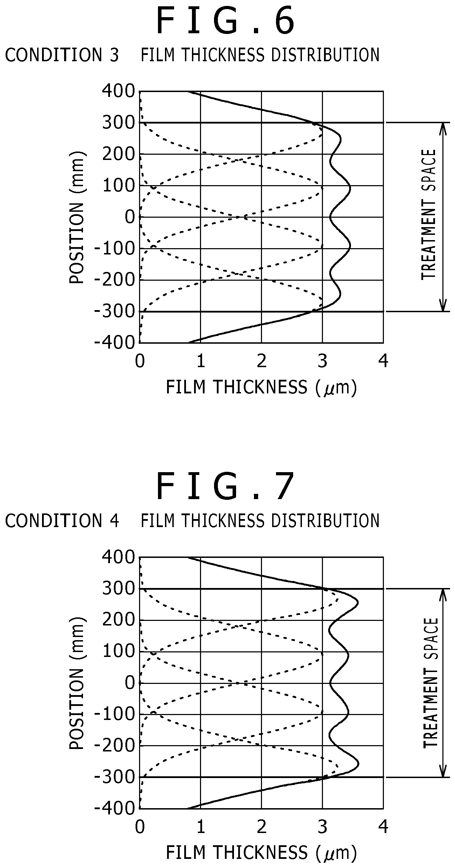

Fig. 6 illustrates the result of the film deposition treatment under Condition 3. The film deposition under Condition 3 corresponds to a third comparative example. In Condition 3, a hard film was formed on the surfaces of the substrates W using all of four evaporation sources 4a to 4d and all the distances (TS distance: X₁) between the evaporation sources 4a to 4d and the substrate sets S were 160 mm. The evaporation sources 4a to 4d were arranged at a regular pitch of 180 mm along the direction of the table rotation axis. As a result, the maximum value of the film thickness of the substrates W was 3.44 µm and the minimum value was 2.88 µm. The central value (mean value) of the film thicknesses of the substrates W was 3.16 µm and the deviation of the film thickness distribution in the substrates W was ±8.9%. In Fig. 6, the curve corresponding to the film thickness distribution acquired by using only a single evaporation source is indicated by a dotted line and the curve corresponding to the film thickness distribution acquired by using the four evaporation sources 4a to 4d is indicated by a solid line. In the latter curve, the declination at the top end and the bottom end of the treatment space is great (film thickness: 2.88 µm). Accordingly, it can be confirmed that the thickness of the hard film formed at both ends in the up and down direction of the substrates W is small.

Fig. 7 illustrates the result of the film deposition treatment under Condition 4. The film deposition under Condition 4 corresponds to the embodiment of the present invention. In Condition 4, a hard film was formed on the surfaces of the substrates W using all of four evaporation sources 4a to 4d. The distance (TS distance: X) between the evaporation source 4a and the substrate sets S and the distance (X) between the evaporation source 4d and the substrate sets S were 140 mm, but the distance (X₁) between the evaporation source 4b and the substrate sets S and the distance (X₁) between the evaporation source 4c and the substrate sets S were 160 mm. That is, the evaporation source 4a and the evaporation source 4d (that is, the first evaporation sources) which are the first evaporation sources arranged at the positions facing both ends of the substrate sets S were arranged so as to further protrude toward the substrate sets S than the evaporation source 4b and the evaporation source 4c which are the second evaporation sources adjacent to the insides of the evaporation source 4a and the evaporation source 4d. The evaporation sources 4a to 4d were arranged at a regular pitch of 180 mm along the direction of the rotation axis.

As a result, the maximum value of the film thickness of the substrates W was 3.57 µm and the minimum value was 3.13 µm. The central value (mean value) of the film thicknesses of the substrates W was 3.35 µm and the deviation of the film thickness distribution in the substrates W was ±6.6%, which was more excellent than the result in Condition 3. In Fig. 7, the curve corresponding to the film thickness distribution acquired by using only a single evaporation source is indicated by a dotted line and the curve corresponding to the film thickness distribution acquired by using the four evaporation sources 4a to 4d is indicated by a solid line. In the latter curve indicating the film thickness distribution, the declination at the top end and the bottom end of the treatment space is small (film thickness: 3.13 µm). It can also be confirmed that the inclinations of the parts corresponding to the evaporation source 4b and the evaporation source 4c in the curve are relatively small but the inclination of the parts corresponding to the evaporation source 4a and the evaporation source 4d are relatively large.

Therefore, according to the embodiment of the present invention, by arranging the plural evaporation sources 4a to 4d as in Condition 4, it is possible to increase the ratio at which evaporated particles emitted from the evaporation sources 4a to 4d reach the substrates W and to acquire a more uniform hard film on the surfaces of the substrates W. It is also possible to increase the central value (mean value) of the film thicknesses of the substrates W.

### [Second Embodiment]

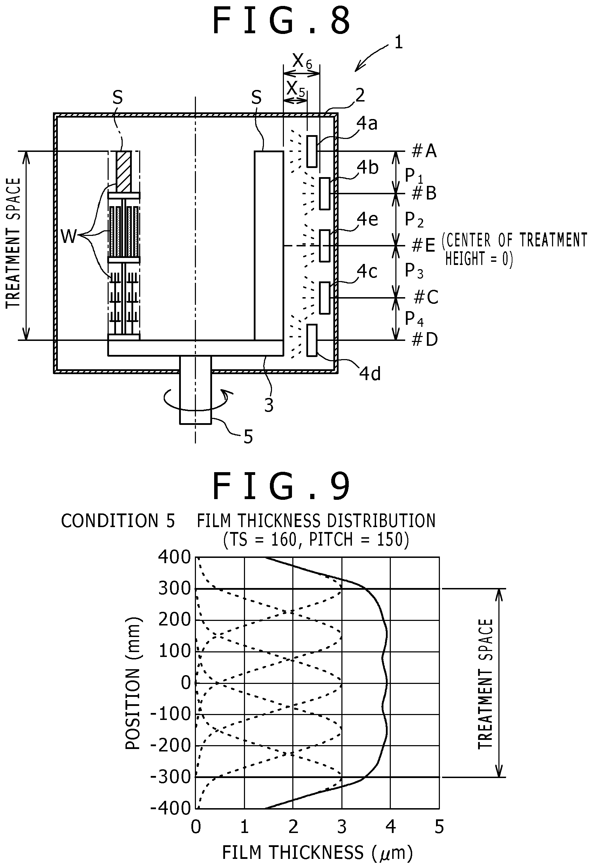

A second embodiment of the present invention will be described below with reference to Figs. 8 to 12. A film deposition device 1 according to the second embodiment includes a worktable 3 that supports plural substrate sets S each including plural substrates W, similarly to the film deposition device 1 according to the first embodiment. A hard film is formed on the substrates W included in each substrate set S while the worktable 3 supports the substrate sets S in an upright posture in which the substrate sets S extend in the up and down direction. In the second embodiment, the posture of the substrate sets S is not limited. For example, even when the substrate sets S are arranged in the vacuum chamber 2 in a posture in which the substrate sets S extend in the right and left direction, it is possible to form a hard film on the substrates W included in each substrate set S.

The configuration of the film deposition device 1 according to the second embodiment of the present invention illustrated in Fig. 8 is substantially equal to the configuration of the apparatus according to the first embodiment (see Fig. 1) illustrated in Fig. 1, in the following points. That is, the film deposition device 1 according to the second embodiment includes a vacuum chamber 2 that accommodates the substrates W, plural evaporation sources that are installed on the inner wall surface of the vacuum chamber 2, and the worktable 3. The worktable 3 supports the substrate sets S and causes the substrate sets S to rotate around the substrate rotation axes in the up and down direction given to the respective substrate sets S. The film deposition device 1 further includes a discharge power source (not illustrated) that causes the plural evaporation sources arranged in the vacuum chamber 2 to generate vacuum arc discharge and a bias power source (not illustrated) that applies a negative voltage to the substrates W placed on the worktable 3.

However, the second embodiment is different from the first embodiment, in that the plural evaporation sources include five evaporation sources 4a, 4b, 4c, 4d, and 4e. The evaporation sources 4a to 4e are installed on the inner wall surface of the vacuum chamber 2 (the right inner wall surface of the vacuum chamber 2 in Fig. 8) and are disposed at height positions #A to #E which can face the substrate sets S placed on the worktable 3. The evaporation sources 4a to 4e have the substantially same size (vertical size). For example, the evaporation materials of the evaporation sources 4a to 4e have a circular shape when viewed from the table rotation axis and have a diameter of about φ100 mm.

As illustrated in Fig. 8, the evaporation source 4a is arranged at the height position #A at which the upper portion of the center in the up and down direction of the evaporation source 4a further protrudes upward than the top end of the substrate sets S. The evaporation source 4d is arranged at the height position #D at which the lower portion of the center in the up and down direction of the evaporation source 4d further protrudes downward than the bottom end of the substrate sets S. The evaporation source 4b, the evaporation source 4c, and the evaporation source 4e are disposed between the evaporation source 4a and the evaporation source 4d. The evaporation sources 4b, 4c, and 4e according to this embodiment are arranged respectively at the height positions #B, #C, and #E which are arranged at a regular gap (regular pitch) along the up and down direction. The arrangement gap of the evaporation sources may be irregular gaps (irregular pitches) depending on experiment conditions to be described later.

The evaporation source 4a and the evaporation source 4d are a pair of first evaporation sources arranged at the positions facing both ends of the substrate sets S, and the evaporation source 4b and the evaporation source 4c are the second evaporation sources arranged to be adjacent to the insides of the evaporation sources 4a and 4d as the first evaporation sources. The evaporation source 4a is disposed to further protrude toward the substrates W than the evaporation source 4b. That is, the evaporation source 4a is disposed to be closer to the substrate set S than the evaporation source 4b. That is, the distance (X₅) between the substrate sets S and the evaporation source 4a is smaller than the distance (X₆) between the substrate sets S and the evaporation source 4b (X₅ < X₆). Similarly to the evaporation source 4a, the evaporation source 4d is disposed to further protrude toward the substrate sets S than the evaporation source 4c. In other words, the evaporation source 4d is disposed to be closer to the substrate sets S than the evaporation source 4c.

The evaporation source 4e corresponds to the third evaporation source adjacent to the insides of the evaporation sources 4c and 4d. The height position of the evaporation source 4e according to this embodiment is the same height position as the center of the treatment height of the substrate sets S, that is, the same height position #E as the height position of the center in the up and down direction of the substrate sets S. In this embodiment, the distance between the evaporation source 4e corresponding to the third evaporation source and the substrate sets S is equal to the distances between the evaporation sources 4b and 4c corresponding to the second evaporation source and the substrate sets S.

That is, the five evaporation sources 4a to 4e according to this embodiment are arranged in an inverted C shape along the direction of the table rotation axis in a front view. The arrangement shape of the five evaporation sources 4a to 4e when viewed from the table rotation axis may be a straight line along the direction of the table rotation axis (that is, the vertical axis direction) or may be a nonlinear shape. For example, the evaporation sources may be arranged in a zigzag shape or a spiral shape.

### [Experimental Examples]

Experimental examples in which a hard film is formed on the surfaces of substrates W using the film deposition device 1 illustrated in Fig. 8 will be described below with reference to the accompanying drawings.

As illustrated in Fig. 8, first, plural substrate sets S (for example, with a height of 600 mm) each including plural substrates W as an object for film deposition are placed on the rotary worktable 3 (for example, φ700 mm) in the vacuum chamber 2. Thereafter, the inside of the vacuum chamber 2 is exhausted to form an almost vacuum state, for example, a state with a nitrogen pressure of about 3 Pa.

On the other hand, an arc current of 100 A is supplied from the discharge power source to the evaporation sources 4a to 4e and a bias voltage of 30 V for applying a negative voltage is applied to the substrates W on the worktable 3 from the bias power source. The process of forming a hard film on the surfaces of the substrates W in this way is continuously performed for two hours. The range (treatment space) in which the film deposition treatment is performed on the substrates W is defined to be the entire length of the substrate sets S in the direction of the substrate rotation axis of the substrate sets S. The position of the treatment center of the substrate sets S (the position of the center in the height direction of the treatment region) of the substrate sets S, is a position 300 mm above the bottom end of the substrate sets S. That is, the central position in the height direction of the treatment region is set to the central position in the direction of the substrate rotation axes (up and down direction) of the substrate sets S.

The results of the experimental examples in which a hard film is formed on the surfaces of the substrates W will be described below with reference to Table 2 and Figs. 9 to 12. Table 2 shows the results of the experimental examples in which a hard film is formed on the surfaces of the substrates W under Conditions 5 to 8 using the film deposition device 1 illustrated in Fig. 8, and Figs. 9 to 12 are graphs illustrating the results of the experimental examples.

**[Table 2]**

| Arrangement of Evaporation Sources and Film Thickness Distribution | | | | | | | | | |
|---|---|---|---|---|---|---|---|---|---|
| (unit: mm) | | | | | | | | | |
| Arrangement of evaporation sources | | Condition 5 (reference condition) | | Condition 6 (only pitch is changed) | | Condition 7 (only TS distance is changed) | | Condition 8 (TS distance and pitch are changed) | |
| | | TS distance | pitch | TS distance | pitch | TS distance | pitch | TS distance | pitch |
| Evaporation source | 4a (#A) | 160 | | 160 | | 140 | | 145 | |
| | | | 150 | | 145 | | 150 | | 148 |
| | 4b (#B) | 160 | | 160 | | 160 | | 160 | |
| | | | 150 | | 155 | | 150 | | 152 |
| | 4e (#E) | 160 | | 160 | | 160 | | 160 | |
| | | | 150 | | 155 | | 150 | | 152 |
| | 4c (#C) | 160 | | 160 | | 160 | | 160 | |
| | | | 150 | | 145 | | 150 | | 148 |
| | 4d (#D) | 160 | | 160 | | 140 | | 145 | |
| Film thickness distribution | Maximum value | 3.92 µm | | 3.95 µm | | 3.92 µm | | 3.88 µm | |
| | Minimum value | 3.46 µm | | 3.52 µm | | 3.70 µm | | 3.69 µm | |
| | Central value | 3.69 µm | | 3.74 µm | | 3.81 µm | | 3.78 µm | |
| | Deviation | ±6.3% | | ±5.8% | | ±3.0% | | ±2.5% | |

Fig. 9 illustrates the result of the film deposition treatment under Condition 5. The film deposition under Condition 5 corresponds to a fourth comparative example. In Condition 5, all the distances (TS distance: X₆) between the evaporation sources 4a to 4e and the substrate sets S were 160 mm. The evaporation sources 4a to 4e were arranged at a regular pitch along the up and down direction. The pitches (P₁ to P₄) between the adjacent evaporation sources were all 150 mm. Conditions 5 serves as a reference of the conditions in the experimental examples using the apparatus illustrated in Fig. 8. As the result of the film deposition under Condition 5, the maximum value of the film thickness of the substrates W was 3.92 µm and the minimum value was 3.46 µm. The central value (mean value) of the film thicknesses of the substrates W was 3.69 µm and the deviation of the film thickness distribution in the substrates W was ±6.3%. As illustrated in Fig. 9, in the curve indicating the film thickness distribution, the declination at the top end and the bottom end of the treatment space is great (film thickness: 3.46 µm). Accordingly, it can be confirmed that the thickness of the film formed at both ends in the length direction of the substrates W is small.

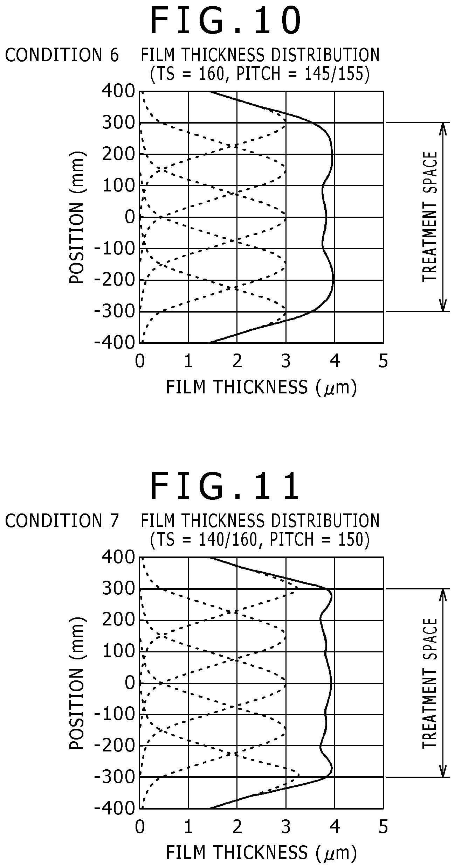

Fig. 10 illustrates the result of the film deposition treatment under Condition 6. The film deposition under Condition 6 corresponds to a fifth comparative example. In Condition 6, the pitches (P₁ to P₄) of the five evaporation sources 4a to 4e in Condition 5 are changed. Specifically, in Condition 6, the pitch (P₁) between the evaporation source 4a and the evaporation source 4b and the pitch (P₄) between the evaporation source 4c and the evaporation source 4d were 145 mm, and the pitch (P₂) between the evaporation source 4b and the evaporation source 4e and the pitch (P₃) between the evaporation source 4e and the evaporation source 4c were all 155 mm. All the distances (TS distance: X₆) between the evaporation sources 4a to 4e and the substrate sets S were 160 mm.

As the result of the film deposition under Condition 6, the maximum value of the film thickness of the substrates W was 3.95 µm and the minimum value was 3.52 µm. The central value (mean value) of the film thicknesses of the substrates W was 3.74 µm and the deviation of the film thickness distribution in the substrates W was ±5.8%. As illustrated in Fig. 10, in the curve indicating the film thickness distribution, the declination at the top end and the bottom end of the treatment space is great (film thickness: 3.52 µm). Accordingly, it can be confirmed that the thickness of the film formed at both ends in the length direction of the substrates W is small.

Fig. 11 illustrates the result of the film deposition treatment under Condition 7. The film deposition under Condition 7 corresponds to the embodiment of the present invention. Condition 7 is different from Condition 5, in that the distances (TS distance: X₅) between the evaporation sources 4a and 4d as a pair of first evaporation sources facing both ends of the substrate sets S and the substrate sets S were all changed to 140 mm. The distance (X₆) between the evaporation source 4b and the substrate sets S, the distance (X₆) between the evaporation source 4e and the substrate sets S, and the distance (X₆) between the evaporation source 4c and the substrate sets S were all changed to 160 mm. That is, the evaporation sources 4a and 4d as a pair of first evaporation sources located at the positions facing both ends of the substrate sets S are disposed to further protrude toward the substrate sets S than any of the plural evaporation sources disposed between the evaporation source 4a and the evaporation source 4d, that is, the evaporation sources 4b and 4c as the second evaporation sources and the evaporation source 4e as the third evaporation source. The pitches (P₁ to P₄) between the adjacent evaporation sources out of the evaporation sources 4a to 4e were all 150 mm.

As the result of the film deposition under Condition 7, the maximum value of the film thickness of the substrates W was 3.92 µm and the minimum value was 3.70 µm. The central value (mean value) of the film thicknesses of the substrates W was 3.81 µm and the deviation of the film thickness distribution in the substrates W was ±3.0%, which was more excellent than the results under Condition 5 and Condition 6. As illustrated in Fig. 11, in the curve indicating the film thickness distribution, it can be seen that the declination (film thickness: 3.70 µm) at the top end and the bottom end of the treatment space is substantially removed.

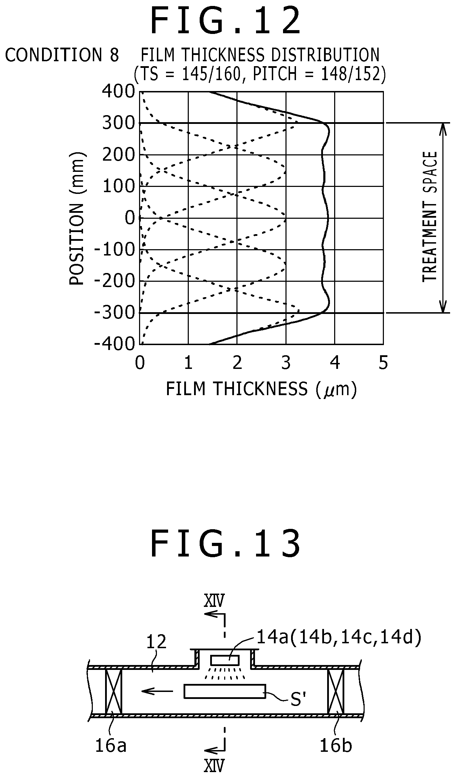

Fig. 12 illustrates the result of the film deposition treatment under Condition 8. The film deposition under Condition 8 also corresponds to the embodiment of the present invention. Condition 8 is different from Condition 5, in that the distances (TS distance: X₅) between the evaporation sources 4a and 4d as a pair of first evaporation sources facing both ends of the substrate sets S and the substrate sets S were all changed to 145 mm. The distance (X₆) between the evaporation source 4b and the substrate sets S, the distance (X₆) between the evaporation source 4c and the substrate sets S, and the distance (X₆) between the evaporation source 4e and the substrate sets S were all 160 mm. The pitches (P₁ to P₄) between the adjacent evaporation sources out of the evaporation sources 4a to 4e were all changed to 145 mm. Accordingly, the evaporation sources 4a and 4d as a pair of first evaporation sources located at the positions facing both ends of the substrate sets S are disposed to further protrude toward the substrate sets S than any of the plural evaporation sources disposed between the evaporation source 4a and the evaporation source 4d, that is, the evaporation sources 4b and 4c as the second evaporation sources and the evaporation source 4e as the third evaporation source. The pitch (P₁) between the evaporation source 4a and the evaporation source 4b and the pitch (P₄) between the evaporation source 4c and the evaporation source 4d were changed to 148 mm, and the pitch (P₂) between the evaporation source 4b and the evaporation source 4e and the pitch (P₃) between the evaporation source 4c and the evaporation source 4e were all changed to 152 mm. That is, the gaps P₁ and P₄ in the up and down direction between the evaporation sources 4a and 4d corresponding to a pair of first evaporation sources and the evaporation sources 4b and 4c corresponding to a pair of second evaporation sources adjacent to the insides thereof are all smaller than the gaps P₂ and P₃ between the evaporation sources 4b and 4c and the evaporation source 4e corresponding to the third evaporation sources adjacent to the insides thereof.

As a result, the maximum value of the film thickness of the substrates W was 3.88 µm and the minimum value was 3.69 µm. The central value (mean value) of the film thicknesses of the substrates W was 3.78 µm and the deviation of the film thickness distribution in the substrates W was ±2.5%, which was more excellent than the result in Condition 7. As illustrated in Fig. 12, in the curve indicating the film thickness distribution, it can be seen that the declination (film thickness: 3.69 µm) at the top end and the bottom end of the treatment space is improved.

In this way, by arranging the evaporation sources 4a and 4d located at the positions facing both ends of the substrate sets S so as to be closer to the substrate sets S, it is possible to form the film on the surfaces of the substrates W in a substantially uniform thickness. It is also possible to increase the central value (mean value) of the film thicknesses of the substrates W. By appropriately changing the pitches in the up and down direction of the evaporation sources 4a to 4e, specifically, by setting the gaps P₁ and P₄ between the evaporation sources 4a and 4d corresponding to the first evaporation sources and the evaporation sources 4b and 4c corresponding to the second evaporation sources to be smaller than the gaps P₂ and P₃ between the evaporation sources 4b and 4c and the evaporation source 4e corresponding to the third evaporation source adjacent to the insides thereof, it is possible to decrease the deviation of the film thicknesses of the films formed on the surfaces of the substrates W.

The arrangement of the evaporation sources 4b, 4c, and 4e can be appropriately changed without departing from the gist of the present invention. In the arrangement illustrated in Fig. 8, the distance between the evaporation source 4b and the substrate sets S, the distance between the evaporation source 4e and the substrate sets S, and the distance between the evaporation source 4c and the substrate sets S are all equal to each other. For example, the distance between the evaporation source 4b and the substrate sets S may be smaller than the distance between the evaporation source 4e and the substrate sets S and may be greater than the distance between the evaporation source 4a and the substrate sets S. Similarly, the distance between the evaporation source 4c and the substrate sets S may be smaller than the distance between the evaporation source 4e and the substrate sets S and may be greater than the distance between the evaporation source 4d and the substrate sets S. That is, the arrangement of the evaporation source 4b, the evaporation source 4e, and the evaporation source 4c is not limited to the arrangement in a straight shape in the up and down direction as illustrated in Fig. 8.

In the film deposition device 1 according to the second embodiment, as illustrated in Fig. 3, the evaporation sources 4a and 4d are disposed to further protrude from the ends of the substrate sets S along the direction of the table rotation axis as the distances between the substrates W and the evaporation sources 4a and 4d as the first evaporation sources increases.

Fig. 13 is a plan view schematically illustrating a film deposition device according to a third embodiment of the present invention. The film deposition device includes a pair of partition walls 16a and 16b that defines a vacuum chamber 12. A substrate support member 13 is installed in the vacuum chamber 12, and substrate sets S' are placed on the substrate support member 13. Similarly to the first embodiment, the film deposition device includes plural evaporation sources 14a to 14d. The evaporation sources 14a to 14d are arranged in the up and down direction, that is, in the direction perpendicular to the drawing paper surface, along one inner wall surface of a pair of inner wall surfaces interposed between both partition walls 16a and 16b. The substrate sets S' are subjected to a film deposition treatment while linearly reciprocating in the horizontal direction, that is, the right and left direction of the drawing paper surface, in the vacuum chamber 12.

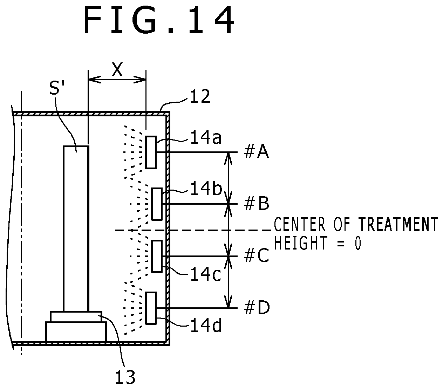

Fig. 14 is a cross-sectional view taken along Line XIV-XIV of Fig. 13. As illustrated in Fig. 14, the evaporation sources 14a to 14d are installed in the vacuum chamber 12 in the same arrangement as in the first embodiment. Accordingly, the third embodiment is different from the first embodiment, in the method of causing the substrate sets S' to move in the vacuum chamber, and both embodiments are equal to each other in the other points. The film deposition process is the same as in the first embodiment.

It should be noted that the embodiments disclosed herein are only examples and are not restrictive. Particularly, in the embodiments disclosed herein, details, which are not explicitly described, such as operating conditions, measuring conditions, various parameters, and the sizes, weights, and volumes of elements do not depart from the ranges to be normally embodied by those skilled in the art, but employ values which can be easily thought out by those skilled in the art.

For example, both the uppermost evaporation source 4a and the lowermost evaporation source 4d out of the evaporation sources 4a to 4d illustrated in Fig. 1 are disposed to further protrude toward the substrates than the other evaporation sources 4b and 4c, but the present invention may include an embodiment in which only one of the evaporation sources 4a and 4d protrudes toward the substrates. For example, when a film is formed with an arrangement in which neither of the evaporation sources 4a to 4d protrude toward the substrates and the film thickness of the upper end of the substrates is remarkably small but the decrease in the film thickness of the lower end is in an allowable range, it is possible to improve the uniformity in the film thickness by causing only the uppermost evaporation source 4a to protrude toward the substrates.

As described above, the present invention provides a film deposition device including the features set forth in claim 1.

According to this apparatus, it is possible to enhance the uniformity in the film thickness on the surfaces of the substrates by arranging the first evaporation source to be closer to the substrates than the second evaporation source adjacent thereto.

The "direction in which the substrate support member causes the substrates to move" means a tangential direction of a movement locus when the substrates move in a locus other than a straight locus.

It is preferable that a worktable which supports the substrates, causes the substrates to rotate around a substrate rotation axis given to the substrates, and rotates around a table rotation axis parallel to the substrate rotation axis be used as the substrate support member.

In the present invention, it is more preferable that two evaporation sources located at both ends in the direction in which the plurality of evaporation sources are arranged out of the plurality of evaporation sources serve as the first evaporation sources.

It is preferable that the first evaporation source be disposed at a position facing at least one of both ends of the substrates in a direction perpendicular to the direction in which the substrate support member causes the substrates to move.

It is preferable that the plural evaporation sources further include a third evaporation source located on a side which is adjacent to the second evaporation source and which is opposite to the first evaporation source, and a gap between the first evaporation source and the second evaporation source adjacent to the inside of the first evaporation source in a direction perpendicular to the direction in which the substrate support member causes the substrates to move be smaller than a gap between the second evaporation source and the third evaporation source adjacent to the inside of the second evaporation source in the direction perpendicular to the direction in which the substrate support member causes the substrates to move. This arrangement enables a decrease in thickness unevenness of the films formed on the surfaces of the substrates.

## Claims

1. A film deposition device (1) for performing a PVD treatment, comprising:
a vacuum chamber (2; 12) having a plurality of substrates (W, S; S') arranged therein;
a substrate support member (3; 13) that is installed in the vacuum chamber (2; 12), supports the substrates (W, S; S'), and is capable of moving the substrates (W, S; S') in the vacuum chamber (2; 12); and
a plurality of evaporation sources (4a to 4e; 14a to 14d) that are installed on an inner wall surface of the vacuum chamber (2; 12) and that are arranged in a line, wherein
the plurality of evaporation sources (4a to 4e; 14a to 14d) include a first evaporation source (4a; 14a) which is located at one end in the direction in which the plurality of evaporation sources (4a to 4e; 14a to 14d) are arranged and a second evaporation source (4b; 14b) adjacent to the first evaporation source (4a; 14a), and
the first evaporation source (4a; 14a) is disposed to further protrude toward the substrates (W, S; S') than the second evaporation source (4b; 14b),
**characterized in that**
the plurality of evaporation sources (4a to 4e; 14a to 14d) are arranged in a direction perpendicular to a direction in which the substrate support member (3; 13) is capable of moving the substrates (W, S; S'), and
the substrate support member (3; 13) supports sets of the substrates (W, S; S') in a posture in which the sets of the substrates (W, S; S') extend in the direction in which the plurality of evaporation sources (4a to 4e; 14a to 14d) are arranged.

2. The film deposition device (1) according to claim 1,
wherein the substrate support member is a worktable (3), and
wherein the worktable (3) supports the substrates (W, S), is capable of rotating the substrates (W, S) around a substrate rotation axis given to the substrates (W, S), and is capable of rotating around a table rotation axis parallel to the substrate rotation axis.

3. The film deposition device (1) according to claim 1,
wherein the plurality of evaporation sources (4a to 4e) further include another first evaporation source (4d; 14d) located at the other end opposite to the one end in the direction in which the plurality of evaporation sources (4a to 4e; 14a to 14d) are arranged.

4. The film deposition device (1) according to claim 1,
wherein the first evaporation source (4a; 14a) is disposed at a position facing one end of the substrates (W, S; S') in a direction perpendicular to the direction in which the substrate support member (3; 13) is capable of moving the substrates (W, S; S').

5. The film deposition device (1) according to claim 1,
wherein the plurality of evaporation sources (4a to 4e) further include a third evaporation source (4e) which is adjacent to the second evaporation source (4b) and is located on a side opposite to the first evaporation source (4a), and
wherein a gap between the first evaporation source (4a) and the second evaporation source (4b) adjacent to the inside of the first evaporation source (4a) in a direction perpendicular to the direction in which the substrate support member (3) is capable of moving the substrates (W, S) is smaller than a gap between the second evaporation source (4b) and the third evaporation source (4e) adjacent to the inside of the second evaporation source (4b) in the direction perpendicular to the direction in which the substrate support member (3) is capable of moving the substrates (W, S).

## Patentansprüche

1. Filmabscheidungsvorrichtung (1) zur Durchführung einer PVD-Behandlung, mit:
einer Vakuumkammer (2; 12), die darin eine Vielzahl von Substraten (W, S; S') angeordnet hat;
einem Substratträgerelement (3; 13), das in der Vakuumkammer (2; 12) installiert ist, die Substrate (W, S; S') trägt und dazu im Stande ist, die Substrate (W, S; S') in der Vakuumkammer (2; 12) zu bewegen; und
einer Vielzahl von Verdampfungsquellen (4a bis 4e; 14a bis 14d), die auf einer Innenwandfläche der Vakuumkammer (2; 12) installiert sind und die in einer Reihe angeordnet sind, wobei
die Vielzahl von Verdampfungsquellen (4a bis 4e; 14a bis 14d) eine erste Verdampfungsquelle (4a; 14a), die sich in der Richtung, in der die Vielzahl von Verdampfungsquellen (4a bis 4e; 14a bis 14d) angeordnet ist, an einem Ende befindet, und eine zweite Verdampfungsquelle (4b; 14b), die an die erste Verdampfungsquelle (4a; 14a) angrenzt, umfasst und
die erste Verdampfungsquelle (4a; 14a) so angeordnet ist, dass sie in Richtung der Substrate (W, S; S') weiter als die zweite Verdampfungsquelle (4b; 14b) vorsteht,
**dadurch gekennzeichnet, dass**
die Vielzahl von Verdampfungsquellen (4a bis 4e; 14a bis 14d) in einer Richtung angeordnet ist, die senkrecht zu einer Richtung ist, in der das Substratträgerelement (3; 13) dazu im Stande ist, die Substrate (W, S; S') zu bewegen, und
das Substratträgerelement (3; 13) Sätze der Substrate (W, S; S') in einer Stellung trägt, in der sich die Sätze der Substrate (W, S; S') in der Richtung erstrecken, in der die Vielzahl von Verdampfungsquellen (4a bis 4e; 14a bis 14d) angeordnet ist.

2. Filmabscheidungsvorrichtung (1) nach Anspruch 1,
wobei das Substratträgerelement ein Werkstücktisch (3) ist und
wobei der Werkstücktisch (3) die Substrate (W, S) trägt, dazu im Stande ist, die Substrate (W, S) um eine den Substraten (W, S) vorgegebene Substratdrehachse zu drehen, und dazu im Stande ist, sich um eine Tischdrehachse zu drehen, die zur Substratdrehachse parallel ist.

3. Filmabscheidungsvorrichtung (1) nach Anspruch 1,
wobei die Vielzahl von Verdampfungsquellen (4a bis 4e) außerdem eine andere erste Verdampfungsquelle (4d; 14d) umfasst, die sich an dem anderen Ende befindet, das in der Richtung, in der die Vielzahl von Verdampfungsquellen (4a bis 4e; 14a bis 14d) angeordnet ist, dem einen Ende gegenüberliegt.

4. Filmabscheidungsvorrichtung (1) nach Anspruch 1,
wobei die erste Verdampfungsquelle (4a; 14a) an einer Stelle angeordnet ist, die in einer Richtung, die senkrecht zu der Richtung ist, in der das Substratträgerelement (3; 13) dazu im Stande ist, die Substrate (W, S, S') zu bewegen, einem Ende der Substrate (W, S; S') zugewandt ist.

5. Filmabscheidungsvorrichtung (1) nach Anspruch 1,
wobei die Vielzahl von Verdampfungsquellen (4a bis 4e) außerdem eine dritte Verdampfungsquelle (4e) umfasst, die an die zweite Verdampfungsquelle (4b) angrenzt und sich auf einer Seite gegenüber der ersten Verdampfungsquelle (4a) befindet, und
wobei ein Spalt zwischen der ersten Verdampfungsquelle (4a) und der zweiten Verdampfungsquelle (4b), die in einer Richtung, die senkrecht zu der Richtung ist, in der das Substratträgerelement (3) dazu im Stande ist, die Substrate (W, S) zu bewegen, an die Innenseite der ersten Verdampfungsquelle (4a) angrenzt, kleiner als ein Spalt zwischen der zweiten Verdampfungsquelle (4b) und der dritten Verdampfungsquelle (4e) ist, die in der Richtung, die senkrecht zu der Richtung ist, in der das Substratträgerelement (3) dazu im Stande ist, die Substrate (W, S) zu bewegen, an die Innenseite der zweiten Verdampfungsquelle (4b) angrenzt.

## Revendications

1. Dispositif de dépôt de film (1) pour effectuer un traitement par dépôt physique en phase vapeur, PVD, comprenant :
une chambre à vide (2 ; 12) ayant, agencés dans celle-ci, une pluralité de substrats (W, S ; S') ;
un élément de support de substrat (3 ; 13) qui est installé dans la chambre à vide (2 ; 12), qui supporte les substrats (W, S ; S'), et qui est capable de déplacer les substrats (W, S ; S') dans la chambre à vide (2 ; 12) ; et
une pluralité de sources d'évaporation (4a à 4e ; 14a à 14d) qui sont installées sur une surface de paroi intérieure de la chambre à vide (2 ; 12) et qui sont agencées en ligne, dans lequel
la pluralité de sources d'évaporation (4a à 4e ; 14a à 14d) comportent une première source d'évaporation (4a ; 14a), qui est située à une extrémité dans la direction dans laquelle sont agencées la pluralité de sources d'évaporation (4a à 4e ; 14a à 14d), et une deuxième source d'évaporation (4b ; 14b) adjacente à la première source d'évaporation (4a ; 14a), et
la première source d'évaporation (4a ; 14a) est disposée de manière à faire davantage saillie vers les substrats (W, S ; S') que la deuxième source d'évaporation (4b ; 14b),
**caractérisé en ce que**
la pluralité de sources d'évaporation (4a à 4e ; 14a à 14d) sont agencées dans une direction perpendiculaire à une direction dans laquelle l'élément de support de substrat (3 ; 13) est capable de déplacer les substrats (W, S ; S'), et
l'élément de support de substrat (3 ; 13) supporte des ensembles des substrats (W, S ; S') dans une posture dans laquelle les ensembles des substrats (W, S ; S') s'étendent dans la direction dans laquelle sont agencées la pluralité de sources d'évaporation (4a à 4e ; 14a à 14d).

2. Dispositif de dépôt de film (1) selon la revendication 1,
dans lequel l'élément de support de substrat est une table porte-pièce (3), et
dans lequel la table porte-pièce (3) supporte les substrats (W, S), est capable de faire tourner les substrats (W, S) autour d'un axe de rotation de substrat donné aux substrats (W, S), et est capable de tourner autour d'un axe de rotation de table parallèle à l'axe de rotation de substrat.

3. Dispositif de dépôt de film (1) selon la revendication 1,
dans lequel la pluralité de sources d'évaporation (4a à 4e) comportent en outre une autre première source d'évaporation (4d ; 14d) située à l'autre extrémité opposée à la première extrémité dans la direction dans laquelle sont agencées la pluralité de sources d'évaporation (4a à 4e ; 14a à 14d).

4. Dispositif de dépôt de film (1) selon la revendication 1,
dans lequel la première source d'évaporation (4a ; 14a) est disposée à une position faisant face à une extrémité des substrats (W, S ; S') dans une direction perpendiculaire à la direction dans laquelle l'élément de support de substrat (3 ; 13) est capable de déplacer les substrats (W, S ; S').

5. Dispositif de dépôt de film (1) selon la revendication 1,
dans lequel la pluralité de sources d'évaporation (4a à 4e) comportent en outre une troisième source d'évaporation (4e) qui est adjacente à la deuxième source d'évaporation (4b) et qui est située sur un côté opposé à la première source d'évaporation (4a), et
dans lequel un écart entre la première source d'évaporation (4a) et la deuxième source d'évaporation (4b) adjacente à l'intérieur de la première source d'évaporation (4a) dans une direction perpendiculaire à la direction dans laquelle l'élément de support de substrat (3) est capable de déplacer les substrats (W, S), est inférieur à un écart entre la deuxième source d'évaporation (4b) et la troisième source d'évaporation (4e) adjacente à l'intérieur de la deuxième source d'évaporation (4b) dans la direction perpendiculaire à la direction dans laquelle l'élément de support de substrat (3) est capable de déplacer les substrats (W, S).
